# EUROPÄISCHE PATENTSCHRIFT

(11) **EP 1 068 580 B1**
(45) Veröffentlichungstag und Bekanntmachung des Hinweises auf die Patenterteilung: **23.01.2002**
(21) Anmeldenummer: 99916779.4
(22) Anmeldetag: 11.03.1999
(51) Int. Cl.: G06F 17/50

(54) **VERFAHREN ZUM VERGLEICH ELEKTRISCHER SCHALTUNGEN**
METHOD FOR COMPARING ELECTRIC CIRCUITS
PROCEDE DE COMPARAISON DE CIRCUITS ELECTRIQUES

(30) Priorität: 30.03.1998 DE 19814109
(43) Veröffentlichungstag der Anmeldung: 17.01.2001
(73) Patentinhaber: SIEMENS AKTIENGESELLSCHAFT, 80333 München (DE)
(72) Erfinder: BORMANN, Jörg, D-81476 München (DE); WARKENTIN, Peter, D-81737 München (DE)
(86) Internationale Anmeldenummer: DE9900674
(87) Internationale Veröffentlichungsnummer: WO9950766

(56) Entgegenhaltungen:
- WO-A-92/18944
- US-A- 5 243 538
- US-A- 5 331 568
- US-A- 5 481 717

## Beschreibung

Die Erfindung betrifft ein Verfahren zum Vergleich elektrischer Schaltungen miteinander.

Beim Entwurf einer digitalen Schaltung benötigt die Qualitätssicherung vor Produktionsbeginn 30% bis 70% der gesamten Entwicklungszeit. Während der Qualitätssicherung wird durch intensive Simulation versucht, Fehler in der Schaltung zu finden. Auch nach Abschluß der Simulation ist nur ein Teil des Verhaltens einer Digitalschaltung untersucht worden, so daß stets in Betracht gezogen werden muß, daß fehlerhafte Entwürfe in Produktion gehen. Eine nach Produktionsbeginn bemerkte Unstimmigkeit in einer elektrischen Schaltung und eine sich daran anschließende Korrektur erfordern zeitaufwendige und teuere Rüstarbeiten.

Die Qualitätssicherung soll sicherstellen, daß Beschreibungsformen unterschiedlicher Phasen des Schaltungsentwurfs für eine Schaltung gleiches Ein-/Ausgabeverhalten aufweisen. Dabei ist es üblich, (digitale) Schaltungen als endliche Automaten mit Booleschen Eingangs-/Ausgangs- und Zustandswerten darzustellen (siehe [1]). Vergleicht man Beschreibungsformen unterschiedlicher Phasen des Schaltungsentwurfs miteinander, so werden dadurch die den Beschreibungsformen zugrundeliegenden Schaltungen verglichen.

Im Rahmen einer Modellgenerierung werden Schaltungen, die sich aus den jeweiligen Entwurfsschritten ergeben, auf endliche Automaten abgebildet. Anschließend wird ermittelt, inwiefern Ein- und Ausgänge der Automaten einander zuzuordnen sind (Input-/Output-Matching). Hinsichtlich dieser Zuordnung wird untersucht, ob bei den Automaten gleiche Eingangswerte auch zu gleichen Ausgaben führen. Ist dies nicht der Fall, wird eine Diagnose erstellt, die dem Benutzer die Analyse des Fehlers erlaubt.

Aus [2] ist ein Verfahren mit dem Ziel bekannt, eine Produktmaschine, also eine Kombination zweier Automaten, zu vereinfachen. Dabei wird die Menge aller Zustandsübergangsfunktionen untersucht und in Teilmengen von Funktionen, die sich auf der Menge der erreichbaren Zustände gleich verhalten, zerlegt. Bei zueinander ähnlichen Automaten enthalten diese Teilmengen gleich viele Funktionen aus beiden Automaten und sind oft sogar zwei-elementig, so daß daraus die Zuordnung der Zustandsvariablen hervorgeht. Ein Nachteil dieses Verfahrens besteht darin, daß Unterschiede zwischen den beiden Automaten nicht zu einem brauchbaren Ergebnis führen. Unterscheiden sich zwei Zustandsübergangsfunktionen, die logisch zusammengehören, so erfolgt keine korrekte Zuordnung.

Unter Zustandscodierung wird eine Repräsentation einer Schaltung in Form eines Automaten verstanden, wobei dieser Automat Zustände und Zustandsübergangsfunktionen aufweist.

Bei einem strukturellen Vergleich zweier Schaltungen handelt es sich um einen Vergleich der die Schaltung darstellenden kombinatorischen Logik unter der Annahme, daß die Zustandscodierungen beider Schaltungen auf gleiche Art erfolgt sind.

Bei einem sequentiellen Vergleich wird gleiches Ein-/Ausgangsverhalten zweier Schaltungen verifiziert, wobei die jeweiligen Schaltungen unterschiedliche Zustandscodierung aufweisen können.

Strukturell gleiche Automaten weisen die gleiche Zustandscodierung auf, strukturell ähnliche Automaten weisen nahezu gleiche Zustandscodierung auf.

Unter einer Zerlegung wird nachfolgend eine Menge verstanden, die aus disjunkten Mengen besteht. Eine Gruppe ist ein Element einer Zerlegung, wobei dieses Element wieder eine Menge darstellt. Eine Teilzerlegung ist eine Teilmenge (=Untermenge) einer Zerlegung. Eine Verfeinerung (einer Zerlegung) ergibt sich aus dem Wortlaut als eine "feinere" Unterteilung der Zerlegung. Der dargestellte Zusammenhang wird anhand eines kurzen Beispiels erläutert:
- Grundmenge:: {a,b,c,d,e}
- Zerlegung:: {{a,b},{c,d},{e}}
- Gruppe:: {a,b} oder {c,d} oder {e}
- Teilzerlegung:: z.B.: {{a,b},{e}} oder
{{a,b}} oder
{{c,d},{e}}
- Verfeinerung:: {{a},{b},{c,d},{e}}

Aus [4] ist ein Verfahren zum Vergleich elektrischer Schaltungen bekannt, bei dem eine Darstellung einer ersten und zweiten Schaltung durch einen ersten und zweiten Automaten vorgegeben ist, bei dem die Zuordnungen zwischen den Eingangs- und Ausgangsvariablen der jeweiligen Automaten vorgegeben ist und bei dem ein Vergleich der beiden Automaten zugrundeliegenden Schaltungen anhand der ermittelten Zuordnungen durchgeführt wird.

Die **Aufgabe** der Erfindung besteht darin, ein Verfahren zum Vergleich elektrischer Schaltungen zu schaffen, dabei den Entwurfsprozeß nicht vollständig durchlaufen zu müssen und anhand einer Abstraktion von Zustandsübergangsfunktionen der Automaten, die die elektrischen Schaltungen beschreiben, ein bei unterschiedlichen, aber strukturell ähnlichen Automaten, effizienten Vergleich zu gewährleisten.

Die zu vergleichenden Schaltungen können aus verschiedenen Beschreibungsformen für den Entwurf einer elektrischen Schaltung hervorgehen. Es ist sicherzustellen, daß die den unterschiedlichen Beschreibungsformen entsprechenden elektrischen Schaltungen gleich sind. Jede Beschreibungsform stellt eine eigene elektrische Schaltung dar.

Die Aufgabe wird gemäß den Merkmalen des unabhängigen Patentanspruchs gelöst.

Es wird ein Verfahren zum Vergleich elektrischer Schaltungen geschaffen, bei dem eine erste Schaltung durch einen ersten Automaten und eine zweite Schaltung durch einen zweiten Automaten dargestellt werden. Eingangsvariablen und Ausgangsvariablen des ersten Automaten werden auf entsprechende Eingangsvariablen und Ausgangsvariablen des zweiten Automaten abgebildet. Eine Grundmenge umfaßt Zustandsvariablen des ersten und des zweiten Automaten. Ausgehend von einer Zerlegung der Grundmenge werden folgende Schritte durchgeführt:
(1) Für jede Zustandsvariable der Zerlegung wird ermittelt, welche Datenabhängigkeiten zwischen Zustandsvariablen, Eingangsvariablen und Ausgangsvariablen bestehen, wobei Zustandsvariablen aus einer Gruppe ununterscheidbar sind;
(2) diejenigen Zustandsvariablen, die gemäß Schritt (1) durch gleiche Datenabhängigkeiten bestimmt sind, werden in einer Gruppe der Zerlegung zusammengefaßt;
(3) Schritt (2) wird für alle Zustandsvariablen durchgeführt, so daß eine Verfeinerung der Zerlegung ermittelt wird;

Zustandsvariablen einer Gruppe der Verfeinerung werden einander zugeordnet und ein Vergleich der den Automaten zugrundeliegenden elektrischen Schaltungen wird anhand der ermittelten Zuordnung durchgeführt.

Ein Schritt zum Vergleich zweier Schaltungen, die jeweils durch einen endlichen Automaten dargestellt sind, miteinander, besteht in der paarweisen Zuordnung je einer Zustandsvariablen beider Automaten zueinander, wodurch festgelegt wird, welche Zustandsübergangsfunktionen verglichen werden sollen und welche Zustandsvariablen beim Vergleich zu identifizieren sind (struktureller Vergleich).

Ein sequentieller Vergleich benötigt eine vorgegebene Variablenordnung, also eine Reihenfolge, in der Zustandsvariablen notiert und verarbeitet werden, wobei diese Reihenfolge erheblich den Aufwand des sequentiellen Vergleichs bestimmt. Wird die Variablenordnung mit dem erfindungsgemäßen Verfahren bestimmt, so ergibt sich eine drastische Reduzierung der Laufzeit des sequentiellen Vergleichs bzw. eine deutlich verminderte Anforderung an bereitzustellenden Speicherplatz.

Eine Weiterbildung der Erfindung besteht darin, daß eine Iteration des Verfahrens derart durchgeführt wird, daß die Verfeinerung der Zerlegung als eine neue Zerlegung eingesetzt wird und mit Schritt (1) fortgefahren wird, solange bis durch eine nächste Iteration keine weitergehende Verfeinerung der Zerlegung bestimmt wird.

Vorteilhaft sind in einer Gruppe eine gleiche Anzahl von Zustandsvariablen des ersten und des zweiten Automaten vorhanden. Die Gruppe heißt in diesem Fall balanciert. Eine Matching-Gruppe ist eine zwei-elementige balancierte Gruppe. Erhält man am Ende der, vorzugsweise iterativen, Anwendung des Verfahrens mehrere Matching-Gruppen, so resultiert daraus eine eindeutige Zuordnung der in der jeweiligen Matching-Gruppe enthaltenen Zustandsvariablen.

Eine andere Weiterbildung besteht darin, daß eine Verfeinerung der Zerlegung durch mindestens eine der folgenden Möglichkeiten erzielt wird:
a) Bei einer Supportmethode werden zu jeder Zustandsvariablen x diejenigen Zustandsvariablen und diejenigen Eingangsvariablen ermittelt, von der die Zustandsübergangsfunktion der Zustandsvariable x abhängt;
b) bei einer inversen Supportmethode werden zu jeder Zustandsvariable diejenigen Zustandsvariablen und diejenigen Ausgangsvariablen ermittelt werden, die von der Zustandsvariable abhängen.

Es sei hierbei angemerkt, daß die Grundmenge vorzugsweise alle Zustandsvariablen beider Automaten umfaßt. Für den jeweiligen Automaten wird für jede Zustandsvariable x die Abhängigkeit von den anderen Zustandsvariablen dieses Automaten ermittelt. Eine mögliche Darstellung erfolgt anhand eines Datenabhängigkeitsgraphen. Der Datenabhängigkeitsgraph umfaßt einen Knoten für jede Zustandsvariable des jeweiligen Automaten und einen Pfeil von einem Knoten u zu einem Knoten v, wenn Knoten u im Support von Knoten v liegt. Umgekehrt liegt dann der Knoten v im inversen Support des Knotens u.

Auch ist es eine Weiterbildung der Erfindung, daß zusätzlich anhand einer Simulationsmethode Verfeinerungen erzeugt werden, indem anhand von Wertebelegungen, die vorzugsweise zufällig erzeugt werden, der Eingangsvariablen und der Zustandsvariablen gleiche Wertebelegungen der den Zustandsvariablen zugrundeliegenden Zustandsübergangsfunktionen ermittelt werden.

Eine andere Weiterbildung der Erfindung besteht darin, anhand einer Vergröberungsmethode eine fehlerhafte bestimmte Verfeinerung der Zerlegung zu korrigieren, indem Gruppen mit jeweils unterschiedlicher Anzahl Zustandsvariablen des ersten Automaten und des zweiten Automaten in einer Gruppe zusammengefaßt werden.

Allgemein wird durch die Vergröberungsmethode unbalancierten Gruppen der Zerlegung, bei denen eine Zuordnung von Zustandsvariablen der beiden zu vergleichenden Automaten nicht erfolgen kann, entgegengewirkt.

Im Rahmen einer zusätzlichen Weiterbildung der Erfindung werden die beiden Automaten sequentiell miteinander verglichen. Gerade bei einem derartigen sequentiellen Vergleich ist es vorteilhaft, wenn die zu vergleichenden Automaten strukturell ähnlich sind. Ein sequentieller Vergleich erfolgt, indem der erste und der zweite Automat miteinander zu einem Produktautomaten verknüpft werden. Sowohl dem ersten als auch dem zweiten Automaten wird ein Eingangssignal angelegt und die resultierenden Ausgangssignale des ersten und des zweiten Automaten werden miteinander verglichen. Vorzugsweise wird ein solcher Vergleich mittels einer EXCLUSIV-ODER-Verknüpfung durchgeführt, die mit einem Ausgangswert "0" (bzw. "FALSE") kennzeichnet, daß die Ausgangssignale der beiden Automaten verschieden sind.

Beim sequentiellen Vergleich werden vorzugsweise binäre Entscheidungsdiagramme (Binary Decision Diagramms = BDDs) eingesetzt (vgl. auch [3]). Eine Variablenordnung legt innerhalb der BDDs fest, in welcher Reihenfolge die Variablen angetragen werden. Durch die Variablenordnung ist in erheblichem Maße vorgegeben, wieviel Speicher die BDDs beanspruchen und in welcher Zeit sie bearbeitbar sind.

Zur Bestimmung der Variablenordnung kann das erfindungsgemäße Verfahren eingesetzt werden. So wird entsprechend der ermittelten Zuordnungen der Zustandsvariablen die Variablenordnung bestimmt, indem einander zugeordnete Zustandsvariablen hintereinander angeordnet werden.

Weiterbildungen der Erfindung ergeben sich auch aus den abhängigen Ansprüchen.

Anhand der folgenden Figuren werden Ausführungsbeispiele der Erfindung näher dargestellt.

Es zeigen
- Fig.1: ein Blockdiagramm, das verschiedene Stufen des Schaltungsentwurfs darstellt,
- Fig.2: ein Blockdiagramm mit Verfahrensschritten zum Vergleich zweier Schaltungen,
- Fig.3: eine erste Skizze mit zwei Zustandsabhängigkeitsgraphen,
- Fig.4: eine zweite Skizze mit zwei Zustandsabhängigkeitsgraphen,
- Fig.5: eine Skizze, die einen Produktautomaten, der einen ersten und einen zweiten Automaten aufweist, darstellt.

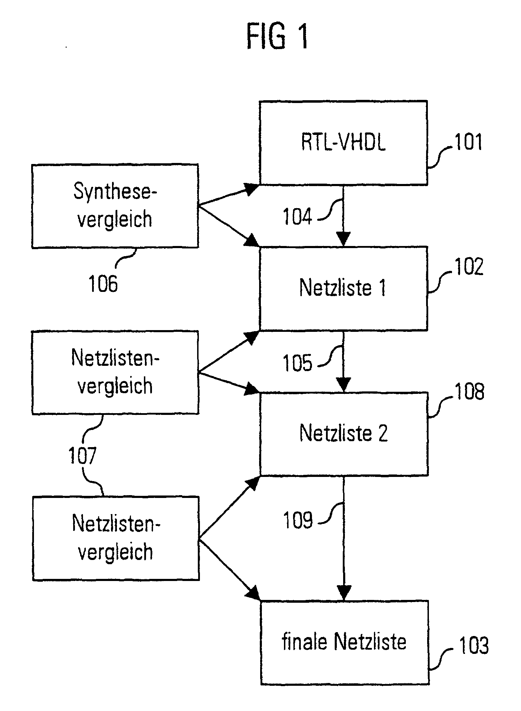

In **Fig.1** ist ein Blockdiagramm dargestellt, das verschiedene Stufen (auch: Phasen) des Schaltungsentwurfs zeigt.

Eine Schaltung kann auf unterschiedliche Art und Weise beschrieben sein. In einem Schritt 101 ist eine Schaltung auf Registerebene beschrieben (engl.: Register-Transfer-Level = RTL). In einem ersten Syntheseschritt 104 wird eine erste Netzliste 102, in einem zweiten Syntheseschritt 105 wird eine zweite Netzliste 108 erstellt. Solche Netzlisten werden in unterschiedlicher Notation dargestellt. Aus der ersten Netzliste 102 wird in mehreren Schritten 104, 105 und 109 eine finale Netzliste 103 erstellt. Mit der finalen Netzliste 103 wird die Schaltung in Produktion gegeben.

Die Schritte 104, 105 und 109 umfassen vorzugsweise eine Optimierung der Logik, wobei die Anzahl der Flip-Flops nach der Optimierung gleich der Anzahl der Flip-Flops vor der Optimierung ist. Weiterhin wird vorzugsweise ein sogenannter "Scan-Path" in die Schaltung eingefügt, der ein Testen des später erstellten Bausteins (Chips) ermöglicht. Auch wird üblicherweise ein Basistakt für den Baustein entsprechend aufgeteilt, so daß dieser in guter Qualität an verschiedenen Stellen im Baustein verfügbar ist ("Clock-Tree").

Während des Entwurfsprozesses durchläuft eine Schaltung mehrere Phasen, wobei mehrere Monate vergehen, ehe aus der RTL-Beschreibung 101 eine entsprechende finale Netzliste 103 entstanden ist. Werden während des Entwurfsprozesses Veränderungen an der RTL-Beschreibung, z.B. aufgrund plötzlich auftauchender Fehler, vorgenommen, so hat dies zumeist signifikante Auswirkung auf die Netzlisten 102, 108 und demzufolge auch auf die finale Netzliste 103. Insbesondere ein erneutes Durchlaufen des gesamten Entwicklungsprozesses zu verhindern und damit den enormen Zeitaufwand zu minimieren, ist anhand der vorliegenden Erfindung möglich.

Sowohl die RTL-Beschreibung 101, die Netzlisten 102 und 108 als auch die finale Netzliste 103 stellen eigenständige Beschreibungen einer einzigen Schaltung dar. Um sicherzugehen, daß wirklich die gleiche Schaltung durch die einzelnen Beschreibungen dargestellt wird, werden die Beschreibungen miteinander verglichen. Zwischen der RTL-Beschreibung 101 und den Netzlisten 102, 108 wird ein sog. Synthesevergleich 106 und zwischen den Netzlisten 102 und 108 oder 102 und 103 ein sog. Netzlistenvergleich 107 durchgeführt. Die den jeweiligen Beschreibungen zugrundeliegenden Schaltungen werden miteinander verglichen und Unterschiede anhand der formalen Verifikation aufgedeckt.

Prinzipiell kann jeder einzelne Prozeßschritt mit einem anderen Prozeßschritt, also jede Beschreibungsform mit jeder anderen Beschreibungsform, verglichen werden.

Jeder Beschreibung liegt ein ähnlicher Boolescher Automat zugrunde, der Eingangs- und Ausgangsvariablen umfaßt. Werden zwei dieser Automaten, miteinander verglichen, so sind die Eingangsvariablen des ersten Automaten auf Eingangsvariablen des zweiten Automaten und entsprechend die Ausgangsvariablen des ersten Automaten auf Ausgangsvariablen des zweiten Automaten abzubilden. Weiterhin existieren in den Automaten zahlreiche Zustandsvariablen, deren Verhalten mittels Zustandsübergangsfunktionen beschrieben wird. Es ist ein weiteres Ziel der Erfindung, Zustandsvariablen des ersten Automaten Zustandsvariablen des zweiten Automaten zuzuordnen, wobei möglichst jede einzelne Zustandsvariable des ersten Automaten einer Zustandsvariablen des zweiten Automaten zugeordnet werden soll. Ein paarweiser Vergleich von Zustandsvariablen ermöglicht eine Verifikation der beiden Automaten.

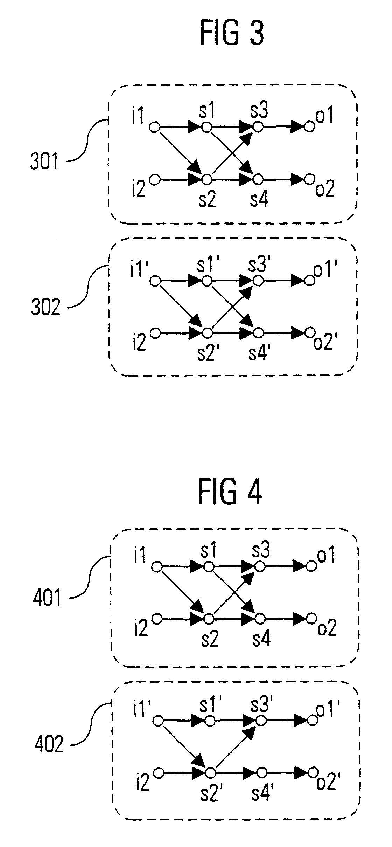

Die endlichen Booleschen Automaten zeigen im Hinblick auf ihr Verhalten in den unterschiedlichen Beschreibungen 101, 102, 108 oder 103 keine großen Unterschiede, da ja (im Idealfall) die gleiche Schaltung beschrieben ist. Die Erfindung verwendet insbesondere Zustandsabhängigkeitsgraphen, um auf die Bedeutung der Zustandsvariablen rückzuschließen und eine Zuordnung der Zustandsvariablen zwischen den Automaten herzustellen. Derartige Zustandsabhängigkeiten sind beispielhaft in den Figuren 3 und 4 dargestellt.

Es werden Notationen und Bezeichnungen eingeführt, die nachfolgend zur Erklärung der Erfindung von Bedeutung sind:

Für zwei Mengen A und B bezeichnen
- A+B: die Vereinigung,
- A*B: den Schnitt (Schnittmenge),
- A-B: die Mengendifferenz und
- {}: die leere Menge.

Als eine Zerlegung Z einer Menge M wird eine Menge von disjunkten, nichtleeren Mengen bezeichnet, deren Vereinigung M ergibt. Ein Element aus Z wird im folgenden eine Gruppe aus Z genannt. Die Verfeinerung Z' einer Zerlegung Z der Menge M ist eine Zerlegung von M mit der Eigenschaft, daß jedes Element von Z' eine (möglicherweise unechte) Teilmenge einer Gruppe aus Z ist.

Eine Faktorisierung A/U einer Untermenge A von M bezüglich einer Teilmenge U der Zerlegung Z von M sei die Menge der Gruppen aus U, die Elemente von A enthalten.

### Beispiel:

Z={{1,2},{3,4,5},{6,7,8}};
U={{1,2},{3,4,5}} und
A={1,6,7}.

Damit ergibt sich:
A/U={{1,2}}.

Sei M eine Menge von Variablen und B die Menge der Booleschen Werte {true, false} so bezeichne B**M die Menge aller möglichen Belegungen der Variablen mit Booleschen Werten.

Ein Boolescher endlicher Automat ist gekennzeichnet durch
- die Menge I seiner Eingangsvariablen (auch: Eingabevariablen),
- die Menge S seiner Zustandsvariablen,
- die zu der Menge S gehörige Boolesche Zustandsübergangsfunktion, die die Menge B**(S*I) nach B**S abbildet,
- die Menge O seiner Ausgangsvariablen (auch: Ausgabevariablen),
- die zu der Menge O gehörige Boolesche Ausgabefunktion, die B**(S+I) nach B**O abbildet und
- INIT eine Menge von Initialzuständen, die eine Untermenge von B**S ist.

Nachfolgend wird davon ausgegangen, daß die Zustandsvariablen, Eingangsvariablen und Ausgangsvariablen der beiden Automaten unterschiedlich benannt sind. S sei von nun an die Menge der Zustandsvariablen beider Automaten. Eine Menge von Variablen heißt balanciert, wenn sie aus jedem der Automaten gleich viele Variablen enthält. Eine Matching-Gruppe ist eine zwei-elementige balancierte Menge.

Mit der Erfindung wird eine sukzessive Verfeinerung der Menge S aller Zustände beider Automaten erreicht. Die einzelnen Zerlegungen sollen dabei so beschaffen sein, daß potentiell zugeordnete Zustandsvariablen stets in derselben Gruppe liegen. Eine eindeutige Zuordnung wird durch Matching-Gruppen festgelegt.

Zunächst werden Eingangs- und Ausgangsvariablen der beiden Automaten einander zugeordnet. In einem Automaten werden die Eingangsvariablen und Ausgangsvariablen durch die jeweils zugeordneten Eingangsvariablen und Ausgangsvariablen des anderen Automaten ersetzt.

Das Verfahren beginnt mit einer geeigneten Ausgangszerlegung Z₀ von S. Vorzugsweise wird dazu die triviale Zerlegung {S} verwendet.

Das Verfahren bestimmt eine Folge Z₀,Z₁,Z₂,... von Zerlegungen. Dabei ist Zᵢ₊₁ im allgemeinen eine Verfeinerung von Zᵢ, die aufgrund der nachfolgend beschriebenen Methoden berechnet wird.

Verfeinerungsmethoden sind die Supportmethode, die inverse Supportmethode und die Simulationsmethode. Welche Verfeinerungsmethoden in welcher Reihenfolge angewandt werden, hängt von dem jeweiligen Einsatzfall ab. Das Verfahren wird beendet, wenn die Zerlegung Zᵢ nur aus Matching-Gruppen besteht oder wenn durch einen weiteren Verfeinerungsschritt keine echte Verfeinerung erzielt wird.

Bei der Supportmethode wird zu jeder Zustandsvariablen x bestimmt, von welchen Zustandsvariablen und Eingangsvariablen ihre Zustandsübergangsfunktion abhängt. Diese Menge wird als Support D(x) von x bezeichnet. Der Support D(x) wird derart modifiziert, daß darin Variablen einer Gruppe ununterscheidbar werden, indem man für jede Gruppe in der Zerlegung Zᵢ genau einen Vertreter bestimmt und die Variablen im Support D(x) durch ihre Vertreter ersetzt. In der neuen Zerlegung kommen zwei Zustandsvariablen genau dann in dieselbe Gruppe, wenn deren modifizierter Support gleich ist und sie in derselben Gruppe der Zerlegung Zᵢ enthalten waren.

Die inverse Supportmethode ist ähnlich zur Supportmethode, nur daß anstatt des Supports D(x) einer Zustandsvariablen x der inverse Support R(x) der Zustandsvariablen x bestimmt wird. Dies entspricht der Menge aller Zustandsvariablen und Ausgangsvariablen, deren Funktionen von der Zustandsvariablen x abhängen.

Die Simulationsmethode bestimmt, vorzugsweise zufällig, eine Anzahl von Wertebelegungen für alle Eingangsvariablen und Zustandsvariablen, bei denen Elemente einer Gruppe immer denselben Wert haben. Dann werden zu jeder Zustandsvariablen die Ergebnisse ihrer Zustandsübergangsfunktion unter diesen Wertebelegungen berechnet. In der neuen Zerlegung kommen zwei Zustandsvariablen genau dann in dieselbe Gruppe, wenn diese Ergebnisse gleich sind und sie bereits vorher in der gleichen Gruppe waren.

Allen Verfeinerungsmethoden ist gemeinsam, daß sie zu jeder Zustandsvariablen eine gewisse Information berechnen und bei dieser Berechnung nicht zwischen Elementen einer Gruppe von Zᵢ unterscheiden. Folglich werden zwei zusammengehörende Zustandsvariablen aus zwei strukturell äquivalenten Automaten nicht auseinandergerissen.

Es folgt eine detaillierte Beschreibung, wie aus einer Zerlegung Zᵢ die jeweils nächste Zerlegung Zᵢ₊₁ berechnet wird.

### SUPPORTMETHODE

Ist I die Menge aller Eingangsvariablen und IM die Zerlegung von I, die der Abbildung der Eingangsvariablen entspricht (=Inputmatching), so ist Y=IM+Zᵢ eine Zerlegung von I+S.

U bezeichnet eine Untermenge aus Y. Weiterhin sei G eine Gruppe aus Zᵢ, die keine Matching-Gruppe ist. Für jede Zustandsvariable x wird der Support D seiner Zustandsübergangsfunktion bestimmt. Es wird G derart aufgeteilt, daß Zustandsvariablen mit gleicher Faktorisierung D/U in derselben Teilgruppe liegen und Zustandsvariablen mit unterschiedlicher Faktorisierung D/U in unterschiedlichen Teilgruppen liegen. Dies wird für jede Gruppe G aus Zᵢ durchgeführt, die keine Matching-Gruppe ist. Zᵢ₊₁ besteht aus allen Teilgruppen, die sich auf diese Weise ergeben, und aus allen Matching-Gruppen aus Zᵢ.

Die exakte Wahl von U bleibt vorzugsweise dem Benutzer überlassen. Möglichkeiten für die Wahl von U sind die Teilmenge der Matching-Gruppen von Y, die Teilmengen der balancierten Gruppen von Y oder die gesamte Menge Y.

### INVERSE SUPPORTMETHODE

O bezeichnet die Menge aller Ausgangsvariablen und OM die Zerlegung in Matching-Gruppen, die der Zuordnung der Ausgangsvariablen entspricht (=Outputmatching). Ferner sei X=OM+Zᵢ eine Zerlegung von O+S. U ist eine Untermenge aus X. Für die Wahl von O gelten die oben beschriebenen Kriterien.

G ist eine Gruppe aus Zᵢ, die keine Matching-Gruppe ist. Für jede Zustandsvariable x aus G wird die Menge R der Zustandsvariablen und Ausgangsvariablen bestimmt, in deren Support x vorkommt. G wird derart aufgeteilt, daß Zustandsvariablen mit gleicher Faktorisierung R/U in derselben Teilgruppe liegen und Zustandsvariablen mit unterschiedlicher Faktorisierung R/U in unterschiedlichen Teilgruppen liegen. Dies wird für alle G aus Zᵢ durchgeführt, die keine Matching-Gruppen sind. Zᵢ₊₁ besteht aus allen Teilgruppen, die sich dabei ergeben und den Matching-Gruppen aus Zᵢ.

### IMPLEMENTIERUNG DURCH VERTRETER

Bei der Implementierung der Supportmethode wird die Faktorisierung D/U nicht durch eine Menge von Mengen dargestellt, sondern durch eine Menge von Vertretern. Dazu wird zu U eine Vertretermenge V bestimmt, d.h. eine Menge, die aus jeder Gruppe aus U genau ein Element enthält. Um die Vertreterdarstellung von D/U zu erhalten, reicht es aus, jedes Element a aus dem Support D zu untersuchen. Gibt es eine Gruppe in U, die a enthält,so wird a durch den Vertreter dieser Gruppe ersetzt, andernfalls wird es gelöscht.

Zur nachfolgenden formalen Beschreibung des Verfahrens wird ein der Programmiersprache PASCAL ähnlicher Pseudocode verwendet. Dabei finden vorzugsweise folgende Sprachkonstrukte Anwendung:
- :=: Variablenzuweisung,
- for each x in M do: Schleifenanweisung, die alle Elemente der Menge M abarbeitet,
- exists v such that Cond(v): wird wahr, wenn es einen Wert für v gibt, mit dem Cond(v) erfüllt wird, und belegt v mit diesem Wert,
- choose any y from M: belegt y mit einem beliebigen Element aus der Menge M,
- choose_subset: Funktion zur Auswahl der Untermenge U aus einer Zerlegung,
- choose_representant: bestimmt den Vertreter einer Gruppe,
- is_matching_group(G): ist wahr für eine Matching-Gruppe G, sonst falsch,
- {}: bezeichnet die leere Menge,
- support(x): bestimmt den Support der Zustandsvariablen x.

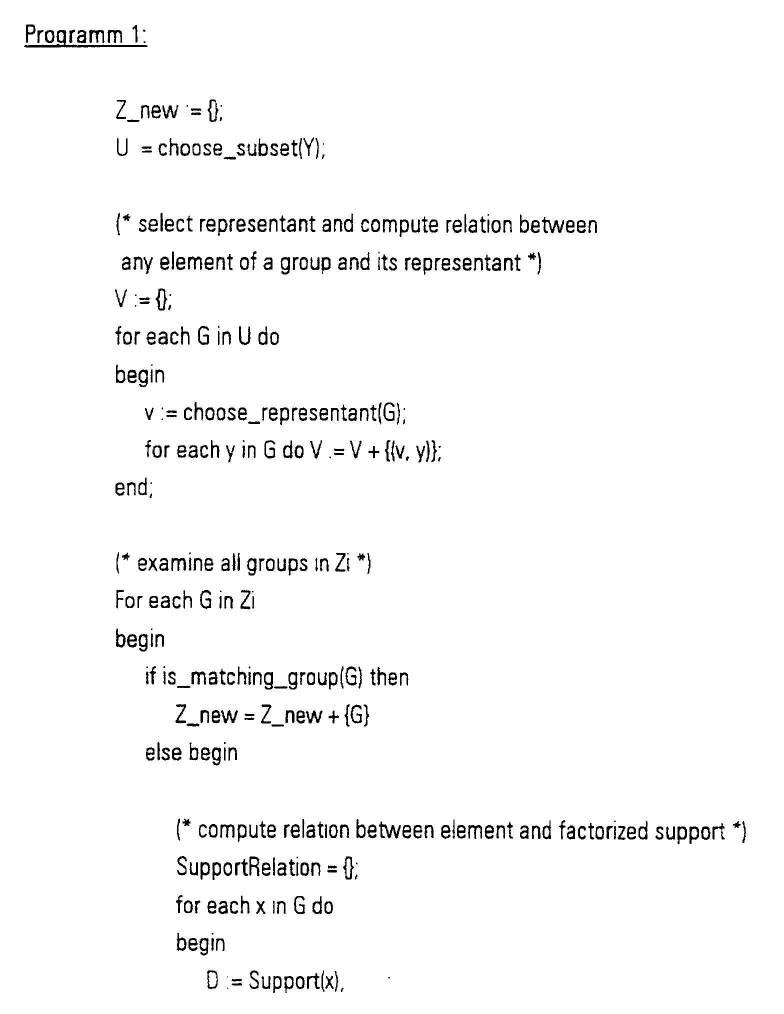

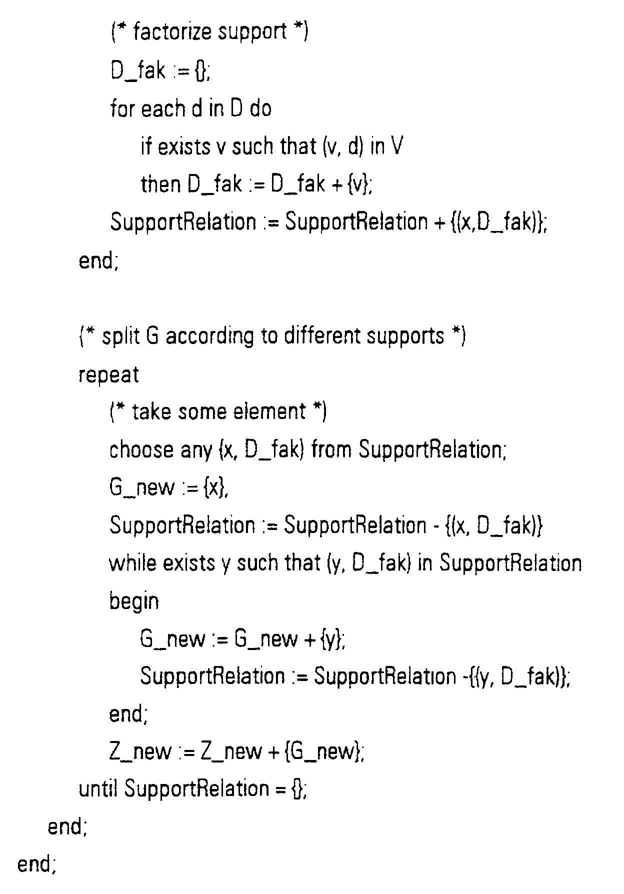

Analog dazu wird die inverse Supportmethode implementiert.

### ALTERNATIVE IMPLEMENTIERUNG

Die nachfolgend dargestellte alternative Implementierung der inversen Supportmethode umgeht eine explizite Bestimmung des inversen Supports. Zu jeder Gruppe M aus U wird der Support D(M) als Vereinigung des Supports der Elemente von M bestimmt. Jede Gruppe G aus Zᵢ, die keine Matching-Gruppe ist, wird so aufgespalten, daß zwei Elemente x und y aus G in derselben Teilgruppe zu liegen kommen, wenn für jedes M aus U gilt, daß x und y entweder beide in D(M) liegen oder keines von beiden darin liegt. Andernfalls sollen sie in verschiedenen Teilgruppen enthalten sein. Zᵢ₊₁ enthält wiederum alle auf diese Art entstandenen Teilgruppen und die Matching-Gruppen aus Zᵢ.

Programm 2 zeigt eine mögliche Implementierung des Verfahrens. Es gilt die gleiche Notation, die oben beschrieben ist, wobei
- matching_groups(Z): die Menge der Matching-Gruppen von Z bezeichnet.

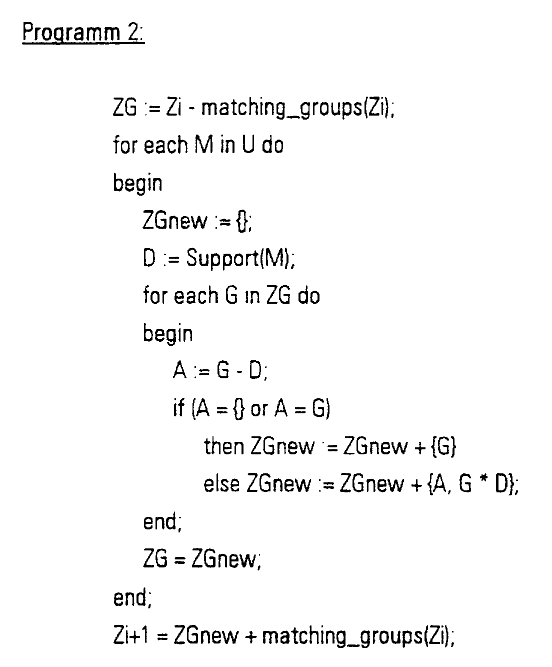

Diese alternative Implementierung basiert darauf, daß y genau dann in dem Support D(x) einer Zustandsvariablen x liegt, wenn die Zustandsvariable x in dem inversen Support R(y) liegt. Für jedes M aus U ist dadurch x aus D(M) gleichbedeutend mit M aus R(x)/U. Aufgrund der alternativen Implementierung bleiben zwei Zustandsvariablen x und y in derselben Gruppe von Zᵢ₊₁, wenn sie in derselben Gruppe von Zᵢ liegen und wenn jedes D(M) entweder beide oder keinen davon enthält, d.h., wenn R(x)/U und R(y)/U beide M enthalten oder keiner M enthält. Damit sind auch R(x)/U und R(y)/U gleich, weil sie Untermengen von U sein müssen. Umgekehrt werden x und y aus einer Gruppe von Zᵢ getrennt, wenn es mindestens ein M gibt, so daß eine von beiden Zustandsvariablen in D(M) liegt und die andere nicht. M ist dann nur in einer der beiden Faktormengen R(x)/U und R(y)/U enthalten und R(x)/U bzw. R(y)/U sind unterschiedlich. Damit ist die Aufteilung Zᵢ₊₁ dieselbe, die auch durch die Anwendung der inversen Supportmethode erhalten wird.

Analog zu dieser Implementierung kann auch die Supportmethode unter Verwendung des inversen Supports implementiert werden.

### SIMULATIONSMETHODE

Es gelte, wie oben vereinbart, Y=IM+Zᵢ als eine Zerlegung von I+S. x ist eine Zustandsvariable und fₓ die korrespondierende Zustandsübergangsfunktion. P sei eine Menge von Wertebelegungen der Zustandsvariablen und Eingangsvariablen, die derart gewählt ist, daß Variablen aus derselben Gruppe von Y mit denselben Werten belegt werden. P wird im allgemeinen nur eine kleine Auswahl aller möglichen Wertebelegungen sein. Insbesondere kann die Menge P zufällig bestimmt werden.

Jede Gruppe G aus Zᵢ, die keine Matching-Gruppe ist, wird in Teilgruppen aufgespalten, so daß zwei Elemente x und y aus G genau dann in derselben Teilgruppe liegen, wenn deren Zustandsübergangsfunktionen fₓ und f_{y} für alle Wertebelegungen aus P dieselben Werte liefern. Zᵢ₊₁ wird wiederum aus den sich auf diese Weise ergebenden Teilgruppen und den Matching-Gruppen aus Zᵢ gebildet.

Programm 3 zeigt eine Implementierung der Simulationsmethode. Es gelten wieder die Bezeichnungen wie oben, zusätzlich:
- P: bezeichnet die Menge von Simulationsstimuli, also nahezu willkürliche Testbelegungen,
- f_{X}(v): bezeichnet die Anwendung der Zustandsübergangsfunktion von x auf die Wertebelegung v,
- generate_patterns(Y): bestimmt die Menge P, wobei Y als Parameter übergeben wird, weil die Wertebelegungen für alle Variablen einer Gruppe von Y gleich sein sollen.

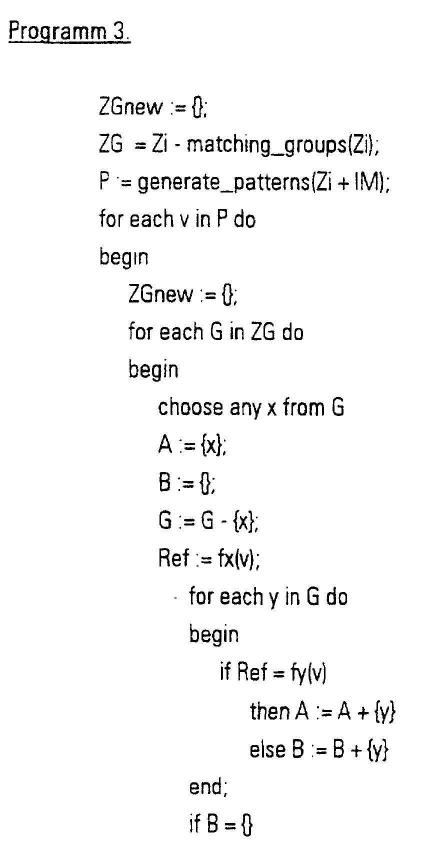

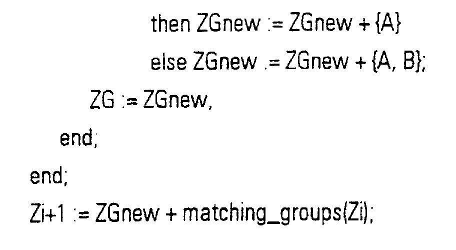

### VERGRÖBERUNGSMETHODE

Die Vergröberungsmethode korrigiert fehlerhafte Aufteilungen, die sich ergeben können, wenn die Automaten zwar strukturell ähnlich, aber nicht gleich sind. Prinzipiell sollen dabei unbalancierte Gruppen wieder zusammengefaßt werden, die in den vorhergehenden Verfeinerungsschritten entstanden sind. Dazu muß eine vorher berechnete Zerlegung Zₖ, k ≤ i bestimmt werden, die als eine Referenzzerlegung dient. Die Vergröberungsmethode bestimmt nun zu jeder Gruppe G aus Zₖ die unbalancierten Teilgruppen in Zᵢ, die Teilmenge von G sind. Diese unbalancierten Teilgruppen werden zu einer Gruppe von Zᵢ₊₁ vereinigt. Zudem soll Zᵢ₊₁ alle balancierten Gruppen von Zᵢ enthalten. Es ist erwünscht, daß durch die Vereinigung zusätzliche balancierte Gruppen oder sogar Matching-Gruppen entstehen.

Welche Referenzzerlegung ausgewählt wird, bleibt dem Einzelfall überlassen. Es sollte jedoch eine Zerlegung ausgewählt werden, die einerseits möglichst kleine Gruppen enthält und von der andererseits angenommen werden kann, daß zusammengehörende Zustandsvariablen in derselben Gruppe liegen. Vorzugsweise wird als Zerlegung Zₖ das Ergebnis der vorhergehenden Vergröberungsmethode bestimmt.

### ERGEBNIS

Im idealen Fall besteht die zuletzt berechnete Zerlegung Z aus lauter Matching-Gruppen, aus denen eine Zuordnung der Zustandsvariablen direkt hervorgeht.

Es können auch unbalancierte Gruppen oder Gruppen mit mehr als zwei Elementen übrig bleiben. Der Grund hierfür kann einerseits darin liegen, daß die zum Aufteilen verwendeten Methoden von den tatsächlichen Zustandsübergangsfunktionen und Ausgabefunktionen abstrahieren. Bei dieser Abstraktion geht Information verloren, die für eine genauere Zuordnung (engl.: Matching) benötigt wird. Andererseits können Redundanzen in der Schaltung vorhanden sein. Wenn beispielsweise beide Automaten je zwei einander zuzuordnende Zustandsvariablen x, y und x', y' mit identischen Zustandsübergangsfunktionen besitzen und x, y bzw. x', y' entweder gemeinsam oder gar nicht im Support der anderen Variablen liegen, dann wird das Verfahren mit einer Zerlegung terminieren, in der es eine Gruppe gibt, die alle vier Zustandsvariablen enthält, weil die Zustandsübergangsfunktionen für die Aufteilung keine Information liefern.

Ein dritter möglicher Grund besteht darin, daß die Automaten zwar ähnlich sind, sich aber doch so unterscheiden, daß einige Zustände nicht zugeordnet werden können.

Für einen sequentiellen Vergleich ist es nicht störend, wenn die Ergebniszerlegung Z Gruppen enthält, die keine Matching-Gruppen sind. Z ist meistens ausreichend fein, um eine neue Variablenordnung für den größeren Automaten zu bestimmen, die ungefähr mit der Variablenordnung des kleineren Automaten übereinstimmt. Auch durch die Umstellung auf diese nicht exakt bestimmte Variablenordnung wird der größere Automat meist kleiner.

Bei einem strukturellen Vergleich müssen die Zustandsvariablen in den störenden Gruppen entweder von dem Vergleich ausgeschlossen werden, oder die Zerlegung muß weiter untersucht werden. Eine derartige weitergehende Untersuchung könnte darin bestehen, daß ein Benutzer zusätzliche Eingaben vornimmt oder eine Zuordnung anhand der Namen der Zustandsvariablen getroffen wird.

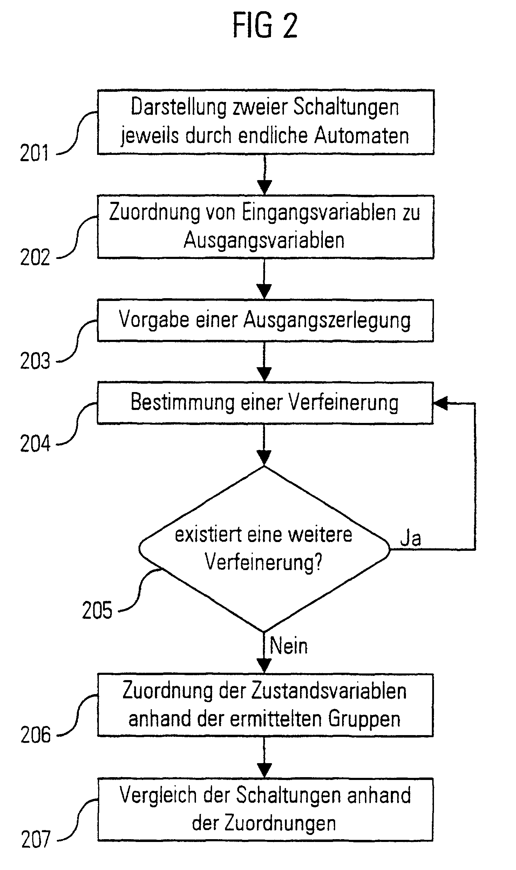

**Fig.2** zeigt ein Blockdiagramm, das Verfahrensschritte zum Vergleich zweier Schaltungen aufweist.

In einem Schritt 201 werden zwei Schaltungen jeweils durch endliche Automaten dargestellt. Vorzugsweise werden dazu Boolesche Automaten verwendet.

In einem Schritt 202 werden Eingangsvariablen des ersten Automaten auf Eingangsvariablen des zweiten Automaten (Inputmatching) und Ausgangsvariablen des ersten Automaten auf Ausgangsvariablen des zweiten Automaten (Outputmatching) abgebildet (Zuordnung der Eingangs- und Ausgangsvariablen). In einem Schritt 203 wird eine Ausgangszerlegung S₀ vorgegeben. In einem Schritt 204 wird eine Verfeinerung der Ausgangszerlegung bestimmt. Eine Abfrage (siehe Schritt 205) stellt fest, ob weitere Verfeinerungen der Zerlegung bestimmt werden können. Ist dies nicht der Fall, so werden die Zustandsvariablen anhand der ermittelten Verfeinerung gemäß den bestimmten Gruppen der durch die Verfeinerung bestimmten Zerlegung zugeordnet (siehe Schritt 206) und in einem Schritt 207 die Schaltungen anhand der getroffenen Zuordnung verglichen. Stellt sich bei der Abfrage in Schritt 205 heraus, daß weitere Verfeinerungen bestimmt werden können, so wird das Verfahren iterativ mit Schritt 204 fortgeführt, die nächste Verfeinerung wird also bestimmt.

### BEISPIELE:

### BEISPIEL FÜR SUPPORTMETHODE UND INVERSE SUPPORTMETHODE

In **Fig.3** sind zwei Zustandsabhängigkeitsgraphen 301 und 302 abgebildet, die gemäß dem Verfahren zum Vergleich zweier Schaltungen auf Unterschiede hin untersucht werden.

Der Zustandsabhängigkeitsgraph 301 besitzt einen Knoten für jede Zustandsvariable und einen Pfeil von Knoten u zu Knoten v, wenn u im Support von v liegt. Nachfolgend bezeichnen:
- i1, i2: Eingangsvariablen des ersten Automaten,
- i1', i2': Eingangsvariablen des zweiten Automaten,
- s1, s2, s3, s4: Zustandsvariablen des ersten Automaten,
- s1', s2', s3', s4': Zustandsvariablen des zweiten Automaten,
- o1, o2: Ausgangsvariablen des ersten Automaten und
- o1', o2': Ausgangsvariablen des zweiten Automaten.

Unter Anwendung der Support-Methode können aus den Zustandsabhängigkeitsgraphen die folgenden Supports abgelesen werden:
D₁ = {i1}, D₂ = {i1, i2}, D₃ = {s1, s2}, D₄ = {s1, s2}, (analog für den zweiten Automaten).

Es wird von der Zerlegung
Z₀ = { {s1, s2, s3, s4, s1', s2', s3', s4'} }
der Zustandsvariablen ausgegangen, d.h.
Y₀ = { {i1, i1'}, {i2, i2'},
{s1, s2, s3, s4, s1', s2', s3', s4'} }.

Es gelte U₀ = Y₀ und {i1, i2, s1} sei die Vertretermenge von U₀. Es ergibt sich (bei Identifikation der Vertreter mit denen von ihnen vertretenen Gruppen):
D₁/U₀ = D_{1'}/U₀ = {i1},
D₂/U₀ = D_{2'}/U₀ = {i1, i2}
D₃/U₀ = D_{3'}/U₀ = {s1},
D₄/U₀ = D_{4'}/U₀ = {s1}.

Die neue Zerlegung Z₁ ergibt sich zu:
Z₁ = {{s1, s1'}, {s2, s2'}, {s3, s4, s3', s4'}}.

Durch erneute Anwendung der Supportmethode ergibt sich mit
Y₁ = { {i1, i1'}, {i2, i2'}, {s1, s1'}, {s2, s2'}, {s3, s4, s3', s4'} }
und mit U₁=Y₁ und der Vertretermenge {i1, i2, s1, s2, s3}:
D₁/U₁ = D_{1'}/U₁ = {i1},
D₂/U₁ = D_{2'}/U₁ = {i1, i2}
D₃/U₁ = D_{3'}/U₁ = {s1, s2}
D₄/U₁ = D_{4'}/U₁ = {s1, s2}

Daraus folgt keine zusätzliche Verfeinerung von Z₁. Die Tatsache, daß schon die zweite Anwendung der Supportmethode keine zusätzliche Verfeinerung liefert, ist eine Besonderheit des Beispiels.

Ausgehend von Z₁ kann anhand der inversen Supportmethode eine weitergehende Verfeinerung gefunden werden. Es gilt:
R₁ = {s3, s4},
R₂ = {s3, s4},
R₃ = {o1}
R₄ = {o2}.

Zu Z₁ ist die Zerlegung der Zustandsvariablen und Ausgangsvariablen:
X₁ = { {o1, o1'}, {o2, o2'}, {s1, s1'}, {s2, s2'}, {s3, s4, s3', s4'} }.

Mit der Vertretermenge V = {o1, o2, s1, s2, s3} gilt:
R₁/X₁ = R_{1'}/X₁ = {s3},
R₂/X₁ = R_{2'}/X₁ = {s3},
R₃/X₁ = R_{3'}/X₁ = {o1},
R₄/X₁ = R_{4'}/X₁ = {o2},
so daß Z₁ verfeinert wird zu:
Z₂ = { {s1, s1'}, {s2, s2'}, {s3, s3'}, {s4, s4'} }.

Damit ist die Zuordnung eindeutig bestimmt, es sind nurmehr Matching-Gruppen vorhanden.

### BEISPIEL FÜR DIE VERGRÖBERUNGSMETHODE

Als Beispiel für die Vergröberungsmethode wird nachfolgend **Fig.4** betrachtet. In Fig.4 sind die beiden Zustandsabhängigkeitsgraphen 401 und 402 dargestellt, die strukturell nicht äquivalent sind.

Die erste Anwendung der Supportmethode verläuft wie im obigen Beispiel zu Fig.3. Es gilt zwar D_{4'}={s2'} (und nicht {s1', s2'} wie oben), dieser Unterschied wird jedoch durch die Faktorisierung nach U₀ ausgeglichen. Damit ergibt sich Z₁ wie oben. Wenn aber die Supportmethode erneut angewandt wird, gilt:
D₁/U₁ = D_{1'}/U₁ = {i1},
D₂/U₁ = D_{2'}/U₁ = {i1, i2},
D₃/U₁ = D_{2'}/U₁ = {s1, s2},
D₄/U₁ = {s1, s2} *aber* D_{4'}/Y₁={s2},
so daß die Gruppe {s3, s3', s4, s4'} für Z₂ zunächst in die Teilgruppen {s3, s3', s4} und {s4'} aufgeteilt würde. Die Vergröberungsmethode (mit k=1) faßt diese Teilgruppen aber wieder zusammen. Dadurch wird vermieden, daß eigentlich zusammengehörende Zustandsvariablen s4 und s4' auseinandergerissen werden. Es kann nach Anwendung der inversen Supportmethode wiederum eine eindeutige Zuordnung getroffen werden.

### IMPLEMENTIERUNGSBEISPIEL

Zusätzlich zu den oben definierten Bezeichnungen gilt im Folgenden:
Support_Methode(Z,X)
Inverse_Support_Methode(Z,X)
Simulations_Methode(Z)
Vergröberungsschritt(Z,Z_Ref)
bezeichnen Anwendungen der jeweiligen Methode (wie oben ausführlich dargelegt). Bei der Supportmethode und der inversen Supportmethode gibt X an, wie U bestimmt wird: Bei
- X=total: sollen alle Gruppen der Zerlegung genommen werden;
- X=matching: sollen nur die Matching-Gruppen verwendet werden.

Weiterhin werden in Programm 4 die Bezeichnungen verwendet:
- Z_Ref: gibt bei dem Vergröberungsschritt (Vergröberungsmethode) an, welche Zerlegung als eine Referenzzerlegung Zₖ bestimmt wird,
- completely_matched(Z): wird wahr, wenn alle Gruppen aus Z entweder Matching-Gruppen sind oder nur Zustandsvariablen eines Automaten umfassen.

Die angegebene Implementierung in Programm 4 ist eine große Schleife, die abbricht, wenn entweder 'completely_matched' erfüllt ist, oder wenn durch die große Schleife keine Aufteilung (weitere Zerlegung) mehr gefunden wird.

Die Anwendung der einzelnen Methoden wird solange wiederholt, bis ein Fixpunkt erreicht ist.

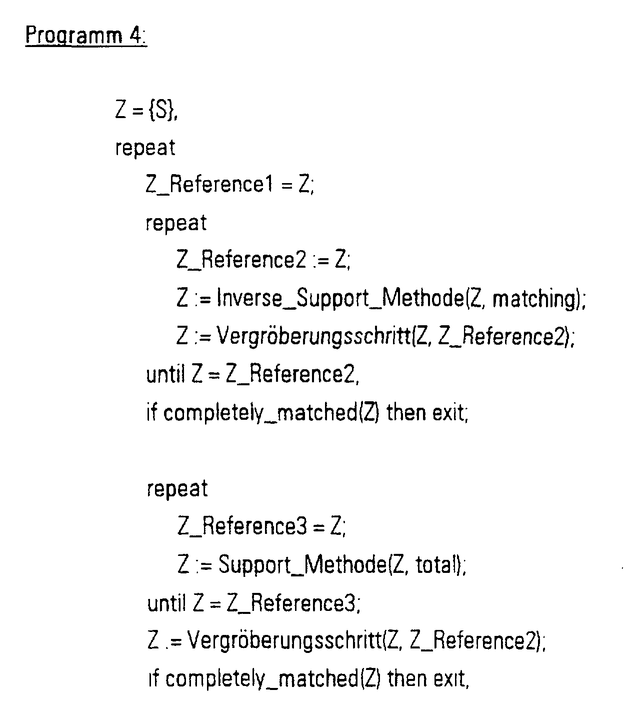

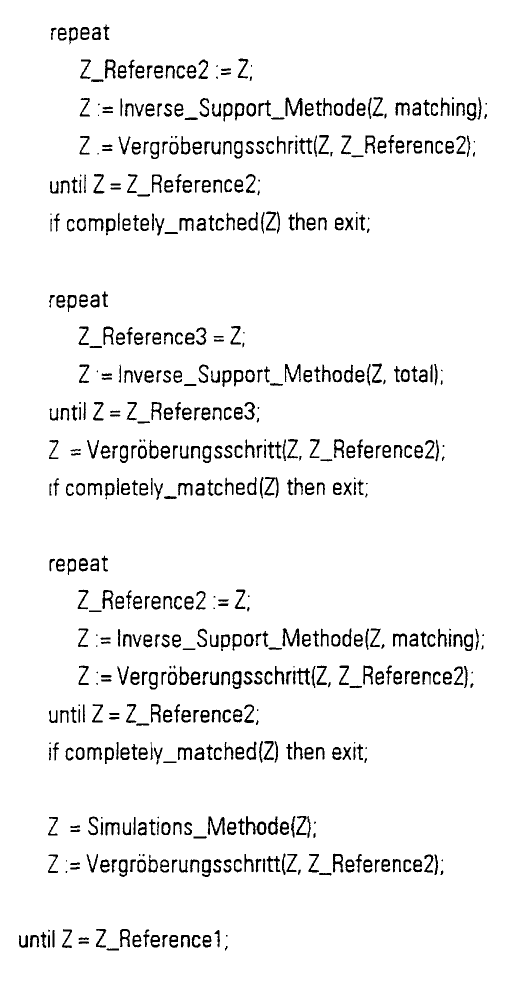

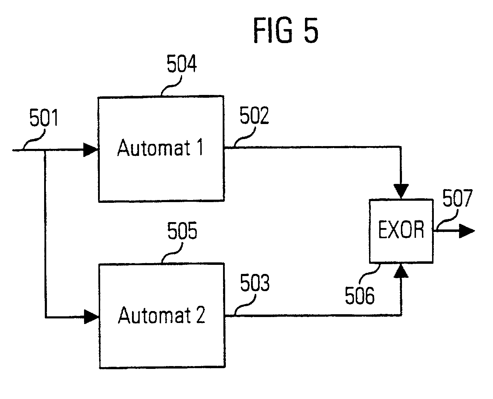

**Fig.5** zeigt einen Produktautomaten, der einen ersten Automaten und einen zweiten Automaten aufweist.

Um einen sequentiellen Vergleich zweier Automaten, die jeweils eine zugrundeliegende elektrische Schaltung darstellen, durchzuführen, werden die beiden Automaten 1 und 2 (siehe Fig.5, 504 und 505) miteinander verschaltet, indem Eingangsvariablen einander zugeordnet und sich ergebende Ausgangswerte 502 und 503 miteinander verglichen werden. Der Vergleich erfolgt vorzugsweise mittels einer EXOR-Verknüpfung, die eine Ungleichheit von Ausgangswerten 502 und 503 mit einer logischen "1" anzeigt.

Für den sequentiellen Vergleich wird eine Variablenordnung [3] benötigt, die durch Matching-Gruppen des erfindungsgemäßen Verfahrens bereitgestellt wird. Vorteilhaft werden Funktionen der endlichen Automaten mittels BDDs (vgl. [3]) dargestellt.

Im Rahmen dieses Dokuments wurden folgende Veröffentlichungen zitiert:
[1] Prof. Dr. Hans-Jochen Schneider (Herausgeber): "Lexikon der Informatik und Datenverarbeitung", R. Oldenbourg Verlag München, 1986, ISBN 3-486-22662-2, Seiten 51-54.
[2] T. Filkorn: Symbolische Methoden für die Verifikation endlicher Zustandssysteme, Dissertation, Institut für Informatik an der Technischen Universität München, 1992, Seiten 82-97.
[3] R. Bryant: Graph-Based Algorithms for Boolean Function Manipulation, IEEE Trans. on Computers, Vol.C-35, No.8, Aug.1996, Seiten 677-691.
[4] US-A-5 331 568 (Pixley Carl) 19. July 1994

## Patentansprüche

1. Verfahren zum Vergleich elektrischer Schaltungen,
a)bei dem eine Darstellung (201) der ersten Schaltung durch einen ersten Automaten (504) vorgegeben ist;
b)bei dem eine Darstellung (201) der zweiten Schaltung durch einen zweiten Automaten (505) vorgegeben ist;
c)bei dem eine Zuordnung (202) der Eingangsvariablen des ersten Automaten auf die Eingangsvariablen des zweiten Automaten und der Ausgangsvariablen des ersten Automaten auf die Ausgangsvariablen des zweiten Automaten vorgegeben ist;
d)bei dem ein Vergleich (207) der beiden den Automaten zugrundeliegenden Schaltungen anhand der ermittelten Zuordnungen durchgeführt wird,
**dadurch gekennzeichnet,**
• **dass** Zustandsvariablen der jeweiligen Gruppe als zueinander zugeordnet betrachtet werden;
• **dass** eine Grundmenge Zustandsvariablen des ersten und des zweiten Automaten enthält und
• **dass** ausgehend von einer vorgegebenen Zerlegung der Grundmenge folgende Schritte durchgeführt werden:
(1)Für jede Zustandsvariable der Zerlegung wird ermittelt (205), welche Datenabhängigkeiten zwischen Zustandsvariablen, Eingangsvariablen und Ausgangsvariablen bestehen, indem
- zu jeder Zustandsvariable diejenigen Zustandsvariablen und diejenigen Eingangsvariablen ermittelt werden, von der die Zustandsübergangsfunktion der Zustandsvariable abhängt und mit diesen ermittelten Variablen die Zerlegung faktorisiert wird sowie
- zu jeder Zustandsvariable diejenigen Zustandsvariablen und diejenigen Ausgangsvariablen ermittelt werden, die von der Zustandsvariable abhängen und mit diesen ermittelten Variablen die Zerlegung faktorisiert wird;
(2)diejenigen Zustandsvariablen, die gemäß Schritt (1) durch gleiche Datenabhängigkeiten bestimmt sind, werden in einer Gruppe der Zerlegung zusammengefaßt (206) ;
(3) Schritt (2) wird für alle Zustandsvariablen durchgeführt, so daß eine Verfeinerung der Zerlegung ermittelt wird.

2. Verfahren nach Anspruch 1,
bei dem eine Iteration derart durchgeführt wird, daß
a) die Verfeinerung der Zerlegung als neue Zerlegung eingesetzt wird und mit Schritt (1) fortgefahren wird, solange bis
b) durch eine weitere Iteration keine weitere Verfeinerung bestimmt wird.

3. Verfahren nach einem der vorhergehenden Ansprüche, bei dem zusätzlich eine Anzahl von Zustandsvariablen in einer Gruppe zusammengefaßt werden, falls für vorgegebene Wertebelegungen der Eingangsvariablen und der Zustandsvariablen anhand der den Zustandsvariablen zugrundeliegenden Zustandsübergangsfunktionen gleiche Wertebelegungen der Zustandssvariablen ermittelt werden.

4. Verfahren nach einem der vorhergehenden Ansprüche, bei dem eine fehlerhafte Verfeinerung korrigiert wird, indem zwei Gruppen mit jeweils unterschiedlicher Anzahl Zustandsvariablen des ersten Automaten und des zweiten Automaten in einer Gruppe zusammengefaßt werden.

5. Verfahren nach einem der vorhergehenden Ansprüche, bei dem der erste Automat und der zweite Automat zu einem Produktautomaten verknüpft werden, wobei eine Variablenordnung ermittelt wird, indem Zustandsvariablen, die einander zugeordnet worden sind, nahe liegend angeordnet werden.

6. Verfahren nach Anspruch 5,
bei dem ein sequentieller Vergleich beider Schaltungen durchgeführt wird, indem durch die Variablenordnung eine Reihenfolge der Zustandsvariablen in binären Entscheidungsdiagrammen bestimmt wird.

## Claims

1. Method for comparing electrical circuits,
a) in which a representation (201) of the first circuit is predetermined by a first automatic device (504);
b) in which a representation (201) of the second circuit is predetermined by a second automatic device (505);
c) in which an association (202) between the input variables of the first automatic device and the input variables of the second automatic device, and between the output variables of the first automatic device and the output variables of the second automatic device, is predetermined;
d) in which a comparison (207) of the two circuits on which the automatic devices are based is carried out using the determined associations,
**characterized**
• **in that** the state variables of the respective group are regarded as being associated with one another;
• **in that** a basic set contains state variables of the first and of the second automatic device, and
• **in that** the following steps are carried out on the basis of a predetermined breakdown of the basic set:
(1) the data relationships between state variables, input variables and output variables are determined (205) for each state variable in the breakdown, in that
- for each state variable, those state variables and those input variables are determined on which the state transfer function of the state variable depends, and the breakdown is factorized using these determined variables, and
- for each state variable, those state variables and those output variables are determined which depend on the state variable, and the breakdown is factorized using these determined variables;
(2) those state variables which are defined by the same data relationships according to step (1) are combined (206) in one group in the breakdown;
(3) step (2) is carried out for all state variables, so that a refinement of the breakdown is determined.

2. Method according to Claim 1,
in which an iteration is carried out in such a manner that
a) the refinement of the breakdown is used as a new breakdown and the process continues with step (1) until
b) no further refinement is obtained from a further iteration.

3. Method according to one of the preceding claims,
in which, in addition, a number of state variables are combined in one group if, for predetermined allocated values for the input variables and for the state variables, the same allocated values of the state variables are determined using the state transfer functions on which the state variables are based.

4. Method according to one of the preceding claims,
in which a faulty refinement is corrected in that two groups which each have a different number of state variables in the first automatic device and in the second automatic device are combined in one group.

5. Method according to one of the preceding claims,
in which the first automatic device and the second automatic device are linked to form a product automatic device, with a variable order being determined in that state variables which have been associated with one another are arranged closely adjacent.

6. Method according to Claim 5,
in which a sequential comparison of the two circuits is carried out in that a sequence of the state variables in binary decision diagrams is established by means of the variable order.

## Revendications

1. Procédé de comparaison de circuits électriques,
a) dans lequel une représentation (201) du premier circuit est donnée par un premier automate (504) ;
b) dans lequel une représentation (201) du second circuit est donnée par un second automate (505) ;
c) dans lequel une association (202) des variables d'entrée du premier automate aux variables d'entrée du second automate et des variables de sortie du premier automate aux variables de sortie du second automate est donnée ;
d) dans lequel une comparaison (207) des deux circuits à la base des automates est exécutée sur la base des associations déterminées,
**caractérisé**
• **en ce que** les variables d'état du groupe respectif sont considérées comme associées les unes aux autres ;
• **en ce qu'**un ensemble de base contient des variables d'état du premier et du second automate, et
• **en ce que**, à partir d'une décomposition donnée de l'ensemble de base, on exécute les étapes suivantes :
(1) pour chaque variable d'état de la décomposition, on détermine (205) quelles fonctions de données existent entre les variables d'état, les variables d'entrée et les variables de sortie,
- en déterminant, pour chaque variable d'état, les variables d'état et les variables d'entrée dont dépend la fonction de changement d'état de la variable d'état et en factorisant la décomposition grâce à ces variables déterminées, et
- en déterminant, pour chaque variable d'état, les variables d'état et les variables de sortie qui dépendent de la variable d'état et en factorisant la décomposition grâce à ces variables déterminées ;
(2) les variables d'état qui sont définies par des fonctions de données identiques selon l'étape (1) sont rassemblées (206) en un groupe de la décomposition ;
(3) l'étape (2) est exécutée pour toutes les variables d'état, de manière à déterminer un affinage de la décomposition.

2. Procédé selon la revendication 1,
dans lequel on exécute une itération de manière à ce que
a) l'affinage de la décomposition commence en tant que nouvelle décomposition et se poursuive avec l'étape (1), jusqu'à ce que
b) aucun affinage supplémentaire ne soit déterminé par une nouvelle itération.

3. Procédé selon l'une quelconque des revendications précédentes, dans lequel on rassemble, en plus, un nombre de variables d'état dans. un groupe pour le cas où, pour des affectations de valeurs données des variables d'entrée et des variables d'état sur la base des fonctions de changement d'état qui sont à la base des variables d'état, des affections de valeurs identiques des variables d'état sont déterminées.

4. Procédé selon l'une quelconque des revendications précédentes, dans lequel on corrige un affinage erroné en rassemblant dans un groupe deux groupes contenant chacun un nombre différent de variables d'état du premier automate et du second automate.

5. Procédé selon l'une quelconque des revendications précédentes, dans lequel le premier automate et le second automate sont combinés pour former un automate produit, un ordonnancement de variables étant déterminé en rapprochant les variables d'état qui sont associées les unes aux autres.

6. Procédé selon la revendication 5,
dans lequel on effectue une comparaison séquentielle des deux circuits en déterminant, grâce à l'ordonnancement de variables, une séquence de variables d'état en diagrammes de décision binaires.
